# EUROPEAN PATENT SPECIFICATION

(11) **EP 4 350 373 B1**
(45) Date of publication and mention of the grant of the patent: **22.07.2026**
(21) Application number: 22211061.1
(22) Date of filing: 02.12.2022
(51) Int. Cl.: G01R 31/367, G01R 31/385, G01R 31/396, G01R 31/389, H01M 10/42, H01M 10/48

(54) **SCREENING METHOD FOR A BATTERY DEVICE, DETECTION METHOD THEREOF, METHOD AND DEVICE FOR SCREENING BATTERY CELLS**
VERFAHREN ZUM SCREENING FÜR EINE BATTERIEVORRICHTUNG, DETEKTIONSVERFAHREN DAFÜR, VERFAHREN UND VORRICHTUNG ZUM SCREENING VON BATTERIEZELLEN
PROCÉDÉ DE CRIBLAGE POUR UN DISPOSITIF DE BATTERIE, PROCÉDÉ DE DÉTECTION ASSOCIÉ, PROCÉDÉ ET DISPOSITIF DE CRIBLAGE D'ÉLÉMENTS DE BATTERIE

(30) Priority: 09.10.2022 CN 202211225683
(43) Date of publication of application: 10.04.2024
(73) Proprietor: CALB Co., Ltd., Changzhou City, Jiangsu Province (CN)
(72) Inventor: MA, Ruijun, Changzhou City, Jiangsu Province (CN); FAN, Fengsong, Changzhou City, Jiangsu Province (CN); WANG, Shengjie, Changzhou City, Jiangsu Province (CN); LIU, Yin, Changzhou City, Jiangsu Province (CN); LI, Kui, Changzhou City, Jiangsu Province (CN)
(74) Representative: Becker, Eberhard

(56) References cited:
- CN-A- 106 124 996
- CN-A- 109 143 106
- CN-A- 111 580 003
- CN-A- 111 580 006
- CN-A- 114 114 024
- CN-A- 114 280 492
- US-A1- 2022 011 373
- NUSEV GJORGJI ET AL: "Fast Impedance Measurement of Li-Ion Battery Using Discrete Random Binary Excitation and Wavelet Transform", IEEE ACCESS, IEEE, USA, vol. 9, 10 February 2021 (2021-02-10), pages 46152 - 46165, XP011846711, DOI: 10.1109/ACCESS.2021.3058368
- WANG LI-FAN ET AL: "Research progress of the electrochemical impedance technique applied to the high-capacity lithium-ion battery", INTERNATIONAL JOURNAL OF MINERALS, METALLURGY AND MATERIALS, BEIJING KEJI DAXUE, CN, vol. 28, no. 4, 1 April 2021 (2021-04-01), pages 538 - 552, XP037422013, ISSN: 1674-4799, [retrieved on 20210412], DOI: 10.1007/S12613-020-2218-6
- HENDRIK ZAPPEN ET AL: "Application of Time-Resolved Multi-Sine Impedance Spectroscopy for Lithium-Ion Battery Characterization", BATTERIES, vol. 4, no. 4, 1 December 2018 (2018-12-01), pages 64, XP055654773, DOI: 10.3390/batteries4040064
- WANG XUEYUAN ET AL: "Fast Calculation of Broadband Battery Impedance Spectra Based on S Transform of Step Disturbance and Response", IEEE TRANSACTIONS ON TRANSPORTATION ELECTRIFICATION, IEEE, vol. 8, no. 3, 22 February 2022 (2022-02-22), pages 3659 - 3672, XP011915998, DOI: 10.1109/TTE.2022.3153680

## Description

### BACKGROUND

### Technical Field

The present disclosure relates to the field of battery technology, in particular to a battery device, a detection method thereof, and a method and device for screening battery cells.

### Description of Related Art

In the preparation process of single cells, due to the differences between batches of materials and the limitations of battery manufacturing processes such as pulping, coating, and rolling, even if the single cells produced in the same batch will be inevitably different from each other in terms of consistency due to the manufacturing process, and therefore the consistency difference between the single cells leads to the difference between the obtained single cells. If these single cells are directly grouped together, it will lead to differences between the battery set, and the consistency between the single cells in the battery set is poor. Therefore, before the batteries are grouped, they will be screened for battery consistency to select single cells with better consistency for grouping.

In the related art, single cells with good consistency under indicators of battery voltage, internal resistance, and capacity and so on are normally selected to form groups. However, not long after the single cell is manufactured, although the single cells with good consistency under indicators of battery voltage, internal resistance, and capacity and so on are selected to form groups, after they are formed into a battery set, they will be placed in storage for a period of time before they are loaded for shipping. Generally, the storage process lasts for a few months or a year. During the storage process, a series of electrochemical changes will spontaneously occur inside the single cell, making the consistency between the single cells worse again.

Therefore, it is a technical problem to be solved urgently by those skilled in the art to provide a battery set which still has good consistency between the single cells after a period of storage and shelving.

CN 111 580 006 A discloses an on-line measurement method of battery dynamic impedance, which comprises the following steps: synthesizing a multi-tone excitation signal by adopting sinusoidal signals with a plurality of frequencies and phases; measuring the battery impedance under a plurality of frequency points simultaneously by using an impedance spectrum time domain measurement of FFT and adopting a multi-tone excitation signal as input; during measurement, a direct current signal of the battery is filtered out as a bias signal, only an alternating current component of voltage/current needs to be tested, FFT (fast Fourier transform) is performed according to the measured alternating current component, and dynamic impedance of the battery is obtained through calculation; measuring dynamic impedance by connecting a plurality of batteries in parallel and in series; the impedance of a plurality of frequency points can be measured at one time, the measurement time of the battery impedance is greatly reduced, the impedance of the battery under the action of charge and discharge current can be reflected, and the real-time online measurement of the battery impedance can be realized.

CN111 580 003 A discloses a method and a device for identifying inconsistency of a secondary battery based on an impedance spectrum in the technical field of battery detection, and aims to solve the technical problems that the inconsistency of the secondary battery is limited in detection and the internal working state of a battery core is not sufficiently reflected in the prior art. The method comprises the following steps: carrying out constant potential EIS test on the secondary batteries with consistent charge states obtained in advance to obtain an impedance spectrum of the secondary batteries; fitting the impedance spectrum; the inconsistency of the secondary battery is identified based on the fitting result.

CN 114 114 024 A discloses a storage battery consistency screening device and a screening method, wherein the screening device comprises an excitation source, a filtering amplification circuit and a signal acquisition circuit, the excitation source is used for outputting sine excitation current to a tested storage battery, the filtering amplification circuit is used for amplifying alternating current components of voltages at two ends of the tested storage battery, the signal acquisition circuit is used for acquiring voltage values output by the filtering amplification circuit, voltage components of the tested storage battery under specific frequency are obtained through Fourier transform calculation, and then alternating current impedance values are obtained through calculation. The matching condition of the detected storage batteries can be obtained only through one round of charging, the storage batteries which can be matched into a group are quickly screened, the matching method fully considers the difference between the capacities of the batteries and the difference between impedances of different batteries during operation, the scientificity and the accuracy of the consistency of the storage battery monomers are guaranteed, the screening time is saved, and the screening efficiency is improved.

CN 106 124 996 A discloses a method for judging the consistency of lithium ion battery monomers, which comprises the following steps: activating a first battery monomer to be detected and a second battery monomer to be detected according to the same charging and discharging mode; performing impedance test on the first battery monomer to be tested and the second battery monomer to be tested based on the electrochemical impedance spectrum principle at a preset temperature; respectively obtaining a first impedance curve and a second impedance curve of the first battery monomer to be tested and the second battery monomer to be tested according to the test result; calculating a difference coefficient of the first impedance curve and the second impedance curve; judging whether the difference coefficient is less than or equal to a preset value; if so, the consistency of the first battery monomer to be tested and the second battery monomer to be tested is good; if not, the consistency of the single battery to be tested and the second single battery to be tested is poor. The method has the advantages of short test period, simple and convenient calculation, no influence on the battery, better accordance with the requirements in actual production and wide application prospect.

CN 109 143 106 A discloses a kind of methods that battery consistency is quickly detected by ac impedance measurement comprising following steps: (1) preparing the battery of ten above models of the same race, the trade mark of the same race, progress Duplicate Samples test; (2) it is up to the test of the battery progress AC impedance of assigned voltage or capacity; (3) DC internal resistance of battery is tested using direct-current discharge method test method; (4) finally, carrying out data processing according to calculating according to the acquisition of the Duplicate Samples data of battery AC impedance and DC internal resistance resistance value size, the coincidence pattern of Nyquist map, overall merit battery with two side terminals quality are analyzed. The present invention passes through ac impedance measurement, the case where main internal resistances such as available ohmic internal resistance, electric charge transfer internal resistance and diffusion internal resistance, wherein ohmic internal resistance also includes electrode plates internal resistance, internal resistance internal resistance due to caused by technique is made, above-mentioned internal resistance situation is compared respectively, and the statistical data that consistency can be obtained is referred to.

### SUMMARY

The invention is set out in the appended set of claims. The following disclosure serves a better understanding of the present invention. Embodiments of the present disclosure provide a screening method for a battery device, a detection method thereof, and a method and a device for screening battery cells, so as to improve the consistency among the individual single cells in a battery module, and the single cells will still have good consistency between them after a period of storage and shelving.

In a first aspect, an embodiment of the present disclosure provides a screening method for a battery device according to claim 1.

In a second aspect, an embodiment of the present disclosure provides a method for screening battery cells according to claim 4.

In a third aspect, an embodiment of the present disclosure provides a detection method for a battery device according to claim 11.

In a fourth aspect, an embodiment of the present disclosure provides a device for screening battery cells according to claim 13.

In a fifth aspect, an embodiment of the present disclosure provides a detection device for a battery device according to claim 14.

The advantageous effects of the present disclosure are as follows:
The screening method for a battery device, the detection method thereof, and the method and device for screening the battery cell provided by the embodiments of the present disclosure have the following advantages:
First, the characteristic values are determined according to the parameters of the two peaks in the frequency-domain impedance diagram, and each peak in the frequency-domain impedance diagram represents a composite impedance including at least diffusion impedance and charge transfer impedance, and different peaks correspond to different weights of diffusion impedance, and different peaks also correspond to different weights of the charge transfer impedance. Therefore, the characteristic values can reflect the magnitude of the charge transfer impedance and diffusion impedance in each battery cell, and then reflect the characteristics of the interface and the characteristics of the solid phase particles during charging and discharging, and further reflect the health and performance of the battery cells. Accordingly, when the ratio of the characteristic values is determined based on the above, screening may be performed based on the ratio to screen out the battery cells that are consistent in terms of health and performance. In this manner, the consistency of the screened battery cells is better, and the performance of the formed battery set is improved.

Second, the battery set screened in this way still have good consistency after storage and shelving, and the consistency between battery cells will not deteriorate after a certain period of storage, so that the battery device may have a better performance.

Third, the solution is able to dynamically monitor the consistency of each battery cell in the battery device, which may reflect the consistency of the battery cell during use, realize the online monitoring of the battery cell, and provide guidance for subsequent use of the battery device.

### BRIEF DESCRIPTION OF THE DRAWINGS

For a better understanding of the disclosure, reference may be made to exemplary embodiments shown in the following drawings. The components in the drawings are not necessarily to scale and related elements may be omitted, or in some instances proportions may have been exaggerated, so as to emphasize and clearly illustrate the features described herein. In addition, related elements or components can be variously arranged, as known in the art. Further, in the drawings, like reference numerals designate same or like parts throughout the several views.
FIG. 1 is a flowchart of a method for screening battery cells provided in an embodiment of the present disclosure.
FIG. 2 is a first frequency-domain impedance diagram provided in an embodiment of the present disclosure.
FIG. 3 is a second frequency-domain impedance diagram provided in an embodiment of the present disclosure.
FIG. 4 is a flowchart of a method for detecting a battery device provided in an embodiment of the present disclosure.
FIG. 5 is a schematic structural diagram of a screening device for battery cells provided in an embodiment of the present disclosure.
FIG. 6 is a schematic structural diagram of a detection device for a battery device provided in an embodiment of the present disclosure.

### DESCRIPTION OF THE EMBODIMENTS

The technical solutions in the exemplary embodiments of the disclosure will be described clearly and explicitly in conjunction with the drawings in the exemplary embodiments of the disclosure. The description proposed herein is just the exemplary embodiments for the purpose of illustrations only, not intended to limit the scope of the invention, so it should be understood that various modifications and variations could be made thereto without departing from the scope of the invention as defined in the appended claims.

In the description of the present disclosure, unless otherwise specifically defined and limited, the terms "first", "second" and the like are only used for illustrative purposes and are not to be construed as expressing or implying a relative importance. The term "plurality" is two or more. The term "and/or" includes any and all combinations of one or more of the associated listed items.

The specific implementations of the battery device, the detection method thereof, the method and the device for screening battery cells provided by the embodiments of the present disclosure will be described in detail below with reference to the accompanying drawings. It should be noted that the described embodiments are only a part of the embodiments of the present disclosure, but not all of the embodiments. Based on the embodiments of the present disclosure, all other embodiments obtained by those of ordinary skill in the art without creative efforts shall fall within the protection scope of the present disclosure.

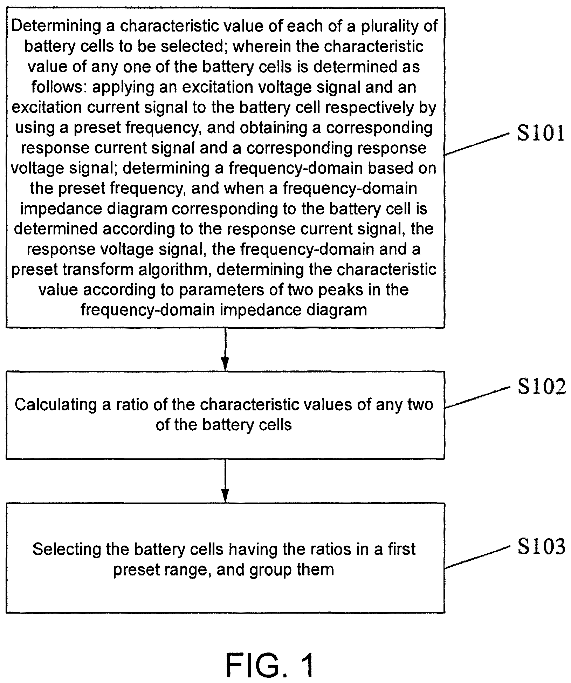

An embodiment of the present disclosure provides a method for screening battery cells, as shown in FIG. 1, which may include:
S101. Determining the characteristic value of each battery cell in the plurality of battery cells to be selected, and the characteristic value of any one of the battery cells is determined as follows: applying an excitation voltage signal and an excitation current signal to the battery cell respectively by using a preset frequency, and obtaining a corresponding response current signal and a corresponding response voltage signal; determining a frequency-domain based on the preset frequency, and when a frequency-domain impedance diagram corresponding to the battery cell is determined according to the response current signal, the response voltage signal, the frequency-domain and a preset transform algorithm, determining the characteristic value according to the parameters of the two peaks in the frequency-domain impedance diagram;
In some embodiments, the adopted preset frequency may be, but is not limited to: determined according to the sampling frequency of a test device (a device capable of providing an excitation current signal and/or an excitation voltage signal, and the test device is different from an impedance test device) or a battery system, or set according to experience.
S102. Calculating a ratio of the characteristic values of any two battery cells;
S103. Selecting the battery cells having the ratios in a first preset range, and grouping them.

In this manner, screening is performed based on the ratio of the characteristic values, so that it is possible to screen out the battery cells that are consistent in terms of health and performance. In this manner, the consistency of the screened battery cells is better, and the performance of the formed battery set is improved.

Moreover, the battery set screened in this way still have good consistency after storage and shelving, and the consistency between battery cells will not deteriorate after a certain period of storage, so that the battery device may have a better performance.

In some embodiments, after completing the above step S103, the method may further include:

Among the selected battery cells, continuously selecting the battery cells with characteristic values in the range of 0.3 to 0.5.

That is to say, after the first screening process of battery cells is completed, a second screening may be performed on the basis of the results of the first screening, so as to achieve selecting the best among the best. In this manner, the health and consistency of the battery cells screened twice may be better and more consistent, so that the performance of the battery set after being grouped is excellent.
1. The following describes the process of determining the characteristic value of a certain battery cell.

The determining process specifically includes:
Step 1. Applying an excitation voltage signal and an excitation current signal to the battery cell respectively by using a preset frequency, and obtaining a corresponding response current signal and a corresponding response voltage signal.

In some embodiments, an excitation voltage signal may be applied to the battery cell first, and the battery cell may be charged and discharged, and a corresponding response current signal may be collected according to a preset frequency.

Then, the excitation current signal is applied to the battery cell, the battery cell is still charged and discharged, and the corresponding response voltage signal is collected according to the preset frequency.

Of course, the excitation current signal may also be applied to the battery cell first to obtain the response voltage signal first; and then the excitation voltage signal may be applied to obtain the response current signal.

Step 2. Determining the frequency-domain based on the preset frequency.

In some embodiments, one-half of the preset frequency may be used as the maximum frequency, and then zero to the maximum frequency may be determined as the frequency-domain.

Of course, the setting may also be made as follows:
The preset frequency is set as the maximum frequency.

Or, one third of the preset frequency is set as the maximum frequency, and so on.

As long as the frequency-domain may be determined according to the preset frequency, so that it is possible to subsequently determine the frequency-domain impedance diagram according to the frequency-domain.

Step 3: Determining the frequency-domain impedance diagram corresponding to the battery cell according to the response current signal, the response voltage signal, the frequency-domain and the preset transform algorithm.

In some embodiments, the preset transform algorithm may include, but is not limited to, Fourier transform algorithm and wavelet transform algorithm, and may also include other transform algorithms that can obtain frequency-domain impedance diagram, which are not limited herein.

In some embodiments, the step of determining the frequency-domain impedance diagram according to the response current signal, the response voltage signal, the frequency-domain, and the preset transform algorithm includes:
Transforming the response current signal and the response voltage signal by using a preset transform algorithm based on the frequency-domain, thereby obtaining the corresponding relationship between the response current signal and the frequency-domain, and the corresponding relationship between the response voltage signal and the frequency-domain;
Determining the frequency-domain impedance diagram according to the corresponding relationships;
When the preset transform algorithm is the Fourier transform algorithm, the frequency-domain impedance diagram is the first frequency-domain impedance diagram; when the preset transform algorithm is the wavelet transform algorithm, the frequency-domain impedance diagram is the second frequency-domain impedance diagram.

In this way, based on different transform algorithms, different types of frequency-domain impedance diagrams may be obtained, so that peak parameters may be extracted from different frequency-domain impedance diagrams, and the characteristic values of battery cells may be determined to provide data as support for the screening of battery cells.

3.1. Take the Fourier transform algorithm as an example.

During a period of time, several response current signals and several response voltage signals may be collected, and each response current signal corresponds to one collection time. For example, I(tᵢ) represents the response current signal collected at the i-th collection time; each response voltage signal also corresponds to one collection time, for example, U(tᵢ) represents the response voltage signal collected at the i-th collection time. Thus, the sequence of response current signals (such as I(t₀), I(t₁), I(t₂), ......, I(tₙ)), and the sequence of response voltage signal (such as U(t₀), U(t₁), U(t₂),......, U(tₙ)) may be obtained.

Then, the response current signal sequence is converted to obtain the current change value sequence at different times; such as △I(t₁) (i.e., I(t₁)-I(t₀)), △I(t₂) (i.e., I(t₂)-I(t₁)), △I(t₃) (i.e., I(t₃)-I(t₂)), △I(t₄) (i.e., I(t₄)-I(t₃)), ......, △I(tₙ) (i.e., I(tₙ)-I(tₙ₋₁)).

The response voltage signal sequence is converted to obtain the voltage change value sequence at different times; such as △U(t₁) (i.e., U(t₁)-U(t₀)), △U(t₂) (i.e., U(t₂)-U(t₁)), △U(t₃) (i.e., U(t₃)-U(t₂)), △U(t₄) (i.e., U(t₄)-U(t₃)), ......, △U(tₙ) (i.e., U(tₙ)-U(tₙ₋₁)).

Afterwards, when n is an even number, it is denoted that N=n, and when n is an odd number, it is denoted that N=n-1. The ratio of fy (representing the preset frequency) to N is calculated. When the frequency-domain is from 0 to fm (fm represents the maximum frequency), fy/N is taken as the step, and 0 to fm is divided into multiple frequency intervals; for example, 0-fy/N is the first frequency interval, fy/N to 2fy/N is the second frequency interval, 2fy/N to 3fy/N is the third frequency interval, until the last frequency interval is divided.

Then, according to the Fourier transform formula, Fourier transform is performed on the current change value sequence at different times and the voltage change value sequence at different times respectively based on the divided frequency intervals, thereby obtaining the current change value sequence at different frequencies (such as △I(f₁), △I(f₂), ......, △I(fₙ)) and voltage change value sequence at different frequencies (such as △U(f₁), △U(f₂), ......, △U(fₙ)). The current change value sequence at different frequencies is the corresponding relationship between the response current signal and the frequency-domain mentioned above, and the voltage change value sequence at different frequencies is the corresponding relationship between the response voltage signal and the frequency-domain mentioned above.

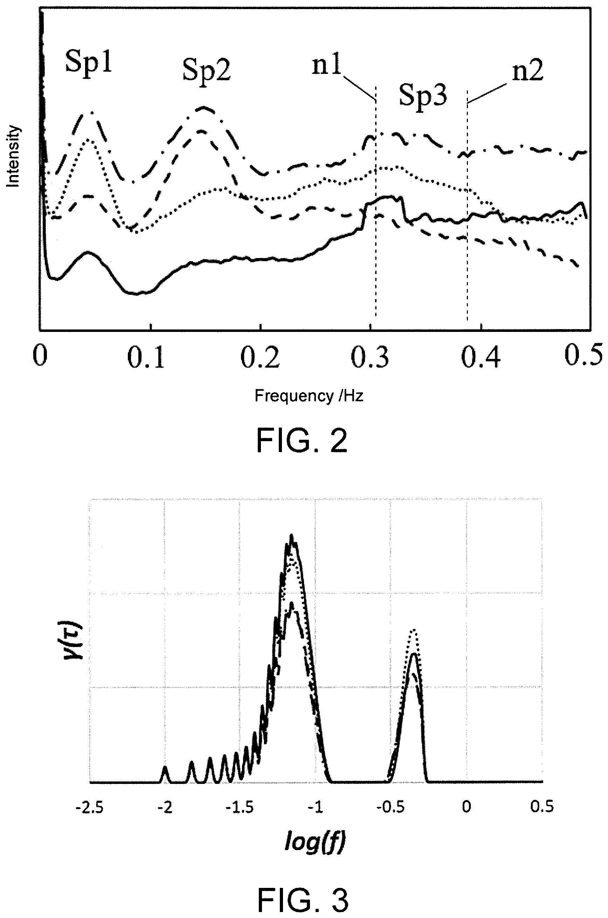

Finally, Z(f₁)=△U(f₁)/△I(f₁), Z(f₂)=△U(f₂)/△I(f₂), ......, Z(fₙ)=△U(fₙ)/△I(fₙ) are calculated respectively based on impedance as the ratio of voltage to current, and the domain impedance diagram is illustrated as shown in FIG. 2.

In conjunction with FIG. 2, three peaks are shown in the figure, and they are marked as Sp1, Sp2 and Sp3 in turn from left to right. The part intercepted by the dotted line n1 and dotted line n2 in FIG. 2 corresponds to the peak Sp3, and each peak corresponds to a composite impedance. Each kind of composite impedance at least includes charge transfer impedance and diffusion impedance. The charge transfer impedance accounts for different weights in different composite impedances, and the diffusion impedance accounts for different weights in different composite impedances. Moreover, the smaller the frequency of the peak, the larger the weight of the diffusion impedance and the smaller the weight of the charge transfer impedance in the corresponding composite impedance. Correspondingly, the larger the frequency of the peak, the smaller the weight of the diffusion impedance and the larger the weight of the charge transfer impedance in the corresponding composite impedance.

Therefore, since the frequencies of the three peaks in an ascending order are: peak Sp1, peak Sp2, and peak Sp3, the weight of diffusion impedance in peak Sp1 is the largest, the weight of diffusion impedance in peak Sp2 is the second largest, and the weight of diffusion impedance in peak Sp3 is the smallest. Correspondingly, the weight of the charge transfer impedance in the peak Sp1 is the smallest, the weight of the charge transfer impedance in the peak Sp2 is the second smallest, and the weight of the charge transfer impedance in the peak Sp3 is the largest.

Further, the setting may be made as follows: the impedance with the largest weight in the composite impedance corresponding to each peak is the impedance represented by the peak.

For example, in peak Sp1, if the corresponding composite impedance includes: charge transfer impedance with a weight of a1%, diffusion impedance with a weight of a2%, and other impedances with a weight of a3%, and a2 is the largest among a1, a2, and a3, then the peak Sp1 may represent the diffusion impedance.

In the peak Sp2, if the corresponding composite impedance includes: charge transfer impedance with a weight of b1%, diffusion impedance with a weight of b2%, and other impedances with a weight of b3%, and b2 is the largest among b1, b2, and b3, then the peak Sp2 may represent diffusion impedance.

In the peak Sp3, if the corresponding composite impedance includes: charge transfer impedance with a weight of c1%, diffusion impedance with a weight of c2%, and other impedances with a weight of c3%, and c1 is the largest among c1, c2, and c3, then the peak Sp3 may represent charge transfer impedance.

3.2. Take the wavelet transform algorithm as an example.

During a period of time, several response current signals and several response voltage signals may be collected, and each response current signal corresponds to one collection time. For example, I(tᵢ) represents the response current signal collected at the i-th collection time; each response voltage signal also corresponds to one collection time, for example, U(tᵢ) represents the response voltage signal collected at the i-th collection time. Thus, the sequence of response current signals (such as I(t₀), I(t₁), I(t₂), ......, I(tₙ)), and the sequence of response voltage signal (such as U(t₀), U(t₁), U(t₂),......, U(tₙ)) may be obtained.

Then, the response current signal sequence is converted to obtain the current change value sequence at different times; such as △I(t₁) (i.e., I(t₁)-I(t₀)), △I(t₂) (i.e., I(t₂)-I(t₁)), △I(t₃) (i.e., I(t₃)-I(t₂)), △I(t₄) (i.e., I(t₄)-I(t₃)), ......, △I(tₙ) (i.e., I(tₙ)-I(tₙ₋₁)).

The response voltage signal sequence is converted to obtain the voltage change value sequence at different times; such as △U(t₁) (i.e., U(t₁)-U(t₀)), △U(t₂) (i.e., U(t₂)-U(t₁)), △U(t₃) (i.e., U(t₃)-U(t₂)), △U(t₄) (i.e., U(t₄)-U(t₃)), ......, △U(tₙ) (i.e., U(tₙ)-U(tₙ₋₁)).

After that, the frequency interval division method described above in section 3.1 may be adopted to divide a plurality of frequency intervals; alternatively, the number and step size of the frequency intervals may also be set in advance, and 0 to fm is divided to divide the set number of frequency intervals according to the set step size.

Then, according to the wavelet transform rule, wavelet transform is performed on the current change value sequence at different times and the voltage change value sequence at different times respectively based on the divided frequency intervals, thereby obtaining the complex coefficients at different frequencies at different times, such as I(f₁), I(f₂), ..., I(fₙ)) and U(f₁), U(f₂), ..., U(fₙ)). As such, each time corresponds to a set of complex coefficients at different frequencies (each set of complex coefficients includes the relationship between current and frequency and the relationship between voltage and frequency), and each set of complex coefficients corresponds to a current change value, and the current change values corresponding to various sets of complex coefficients are different, from which the set of complex coefficients with the largest current change value is selected as the corresponding relationship between the response current signal and the frequency-domain and the corresponding relationship between the response voltage signal and the frequency-domain.

Finally, Z(f₁)=U(f₁)/I(f₁), Z(f₂)=U(f₂)/I(f₂), ..., Z(fₙ)=U(fₙ)/I(fₙ) are calculated respectively based on impedance as the ratio of voltage to current, and DRT analysis is performed on the obtained impedance, and the domain impedance diagram is illustrated as shown in FIG. 3.

In conjunction with FIG. 3, two peaks are shown in the figure, and they are marked as Sp4 and Sp5 in turn from left to right. Each peak corresponds to a composite impedance. Each kind of composite impedance at least includes charge transfer impedance and diffusion impedance. The charge transfer impedance accounts for different weights in different composite impedances, and the diffusion impedance accounts for different weights in different composite impedances. Moreover, the smaller the frequency of the peak, the larger the weight of the diffusion impedance and the smaller the weight of the charge transfer impedance in the corresponding composite impedance. Correspondingly, the larger the frequency of the peak, the smaller the weight of the diffusion impedance and the larger the weight of the charge transfer impedance in the corresponding composite impedance.

Therefore, the peak Sp4 may represent the diffusion impedance, and the peak Sp5 may represent the charge transfer impedance.

In FIG. 3, f represents frequency, log(f) represents the logarithm of the frequency, and γ(τ) represents the relaxation time distribution function.

Step 4. Determining the characteristic values according to the parameters of the two peaks in the frequency-domain impedance diagram.

### 4.1. Regarding the first frequency-domain impedance diagram

In some embodiments, the characteristic value may be determined according to the peak value ratio of two of the multiple peaks within the range of 0.01 Hz to 0.5 Hz in the first frequency-domain impedance diagram; under the circumstances, the parameter of the selected peak is the peak value, or may be interpreted as the intensity of the peak.

In this way, when the characteristic value of the battery cell is determined based on the intensity of the peak, the amount of data calculation is less, the operation processing process is relatively simple. As such, the efficiency and accuracy of determining the characteristic value may be improved, and the manufacturing cost of the processor may also be reduced.

Of course, in some embodiments, when determining the characteristic value, it is not limited to performing the determining process based on the peak value ratio of the two peaks, and the characteristic value may also be determined according to the difference between the peak values of the two peaks, or the characteristic value may also be determined based on the ratio of the integral area of one of the two peaks, which may be set according to actual needs, and the disclosure provides no limitation thereto.

In some embodiments, the step of determining the characteristic value according to the peak value ratio of two of the plurality of peaks in the range of 0.01 Hz to 0.5 Hz in the first frequency-domain impedance diagram includes:
Determining the frequency corresponding to each peak in the plurality of peaks within the range of 0.01Hz to 0.5Hz in the first frequency-domain impedance diagram;
Defining the peak intensity of the peak with the largest frequency among the multiple peaks as the first peak value, and defining the peak intensity of the peak with the smallest frequency among the multiple peaks as the second peak value;
Determining the characteristic value according to the ratio of the first peak value to the second peak value.

For example, in conjunction with FIG. 2, the first peak value (e.g., peak Sp3) is the peak value of the peak with the largest frequency, and therefore the charge transfer impedance in the composite impedance corresponding to the first peak value has the largest weight. Accordingly, the impedance corresponding to the first peak value may be considered as charge transfer impedance. The second peak value (such as peak Sp1) is the peak value of the peak with the smallest frequency, and therefore the weight of the diffusion impedance in the composite impedance corresponding to the second peak value is the largest. Accordingly, the impedance corresponding to the second peak value may be considered as the diffusion impedance.

When the characteristic value is determined based on the ratio of the first peak value to the second peak value, the relationship between the charge transfer impedance and the diffusion impedance may be reflected. For example, when the characteristic value is large, it means that the charge transfer impedance is large, and/or the diffusion impedance is small. When the charge transfer impedance is large, it is likely to cause a large overvoltage at the interface during charging and discharging, which will reduce the service life of the battery cell and cause the performance of the battery cell to decline. When the diffusion impedance is small, the particle size of the solid phase particles is abnormally small, or the insulating film has defects such as damage and pores, which will also reduce the service life of the battery cell and cause the performance of the battery cell to decline.

When the characteristic value is small, it means that the charge transfer impedance is small, and/or the diffusion impedance is large. When the charge transfer impedance is small, it means that the passivation film at the interface is too thin or the passivation effect is poor, which will reduce the service life of the battery cell and result in a decline in the performance of the battery cell. When the diffusion impedance is large, it means that the particle size of the solid phase particles is abnormally large, or the insulating film has defects such as damage and pores, which will still reduce the service life of the battery cell and causes the performance of the battery cell to decline.

Therefore, the characteristic values may be adopted to reflect the characteristics of the interface and the characteristics of the solid phase particles during charging and discharging, and further reflect the health and performance of the battery cells. As such, when the ratio of the characteristic values is determined based on the above, and the screening is performed based on the ratio of the characteristic values, it is possible to screen out the battery cells with better consistency in terms of health and performance, so that the consistency of the screened battery cells is better, and the performance of the formed battery set is excellent.

Of course, in some embodiments, in addition to selecting the peak with the largest frequency and the peak with the smallest frequency, it is also possible to select two peaks with a large frequency difference among multiple peaks with better peak shape (that is, a peak with a larger peak intensity and a smaller peak width), and the disclosure is not limited thereto. For example, but not limited to, as shown in FIG. 2, the peak shape of the peak Sp1 and the peak Sp2 is better, and the peak shape of the peak Sp3 is slightly worse due to the larger width of the peak, so the ratio of the intensities of the peak Sp1 and the peak Sp2 may be selected to determine the characteristic value.

### 4.2. Regarding the second frequency-domain impedance diagram

In some embodiments, the characteristic value may be determined according to the integral area ratio of one of the two peaks in the range of 10^{-2.5}Hz to 10^{0.5}Hz in the second frequency-domain impedance diagram; under the circumstances, the parameters of the selected peak is the integral area.

In this way, when the characteristic value of the battery cell is determined based on the integral area of the peak, as compared with performing the determining process based on the intensity of the peak, the result shows the influence of more factors, and exhibits an overall effect, so the determined characteristic value is more consistent with the actual condition of the battery cell. Therefore, when the battery cells are screened to be grouped, the consistency of the screened battery cells is better, and the performance after grouping is better.

Of course, in some embodiments, determining the characteristic value is not limited to the determining process based on the integral area ratio of one of the peaks, but may also be determined based on the ratio or difference of the integral areas of the two peaks, or determined based on the ratio of the intensities of two peaks, the disclosure is not limited thereto.

In some embodiments, the step of determining the characteristic value according to the integral area ratio of one of the two peaks within the range of 10^{-2.5} Hz to 10^{0.5} Hz in the second frequency-domain impedance diagram includes:

Determining the integral area of each of the two peaks within the range of 10^{-2.5} Hz to 10^{0.5} Hz in the second frequency-domain impedance diagram;

Determining the characteristic value according to the ratio of the integral area of the peak with smaller frequency to the sum of the integral areas of the two peaks.

For example, as shown in FIG. 3, the peak with a smaller frequency is the peak Sp4, and the peak Sp4 may represent the diffusion impedance, and the peak with a larger frequency is the peak Sp5, and the peak Sp5 may represent the charge transfer impedance. The sum of the integral area of the peak Sp4 and the integral area of the peak Sp5 is defined as the total area, so the ratio of the integral area of the peak Sp4 to the total area may be used as a characteristic value.

When the characteristic value is determined based on the ratio of the integral area of the peak with a smaller frequency to the sum of the integral areas of the two peaks, and the diffusion impedance and the charge transfer impedance are referred to as the characteristic impedance, it is possible to reflect the proportion of the diffusion impedance in the characteristic impedance. In this way, when the characteristic value is large, it means that the diffusion impedance accounts for a large proportion in the characteristic impedance, which reflects the significant structural inhomogeneity inside the battery cell, that is, the reaction rate or degree of reaction at different structural positions varies significantly during charging and discharging. Moreover, it is reflected that the particle size of the solid phase particles is abnormally large, or the insulating film has defects such as damage and pores, resulting in poor performance and service life of the battery cell.

When the characteristic value is small, it means that the diffusion impedance accounts for a small proportion in the characteristic impedance, and correspondingly the charge transfer impedance accounts for a large proportion in the characteristic impedance, which is likely to cause a large overvoltage at the interface during charging and discharging, and it also indicates that the passivation film at the interface is too thick, and the electronic conduction or ion conduction performance inside the battery cell is poor, which will reduce the service life of the battery cell and cause the performance of the battery cell to decline.

Therefore, the characteristic values can reflect the characteristics of the interface and the characteristics of the solid phase particles during charging and discharging, and further reflect the health and performance of the battery cells. Accordingly, when the ratio of the characteristic values is determined based on the above, screening may be performed based on the ratio of characteristics values to screen out the battery cells that are consistent in terms of health and performance. In this manner, the consistency of the screened battery cells is better, and the performance of the formed battery set is improved.

Of course, in some embodiments, in addition to selecting the ratio of the integral area of the peak with a smaller frequency to the sum of the integral areas of the two peaks, it is also possible to select the ratio of the integral area of the peak with the higher frequency to the sum of the integral areas of the two peaks as long as the selected ratio can reflect that the diffusion impedance and the charge transfer impedance are within an appropriate range. The disclosure is not limited thereto.

To sum up, after the characteristic values are determined based on the above process, the battery cells may be screened based on the characteristic values, so as to screen out the battery cells with better consistency and health, so as to improve the performance of the assembled battery set.

In some embodiments, the step of grouping the screened battery cells may include:
Determining the integral area of the peak within the reference frequency band of the selected battery cells from the first frequency-domain impedance diagram or the second frequency-domain impedance diagram;
Determining the lithium deposition risk level of various battery cells according to the integral area of the peak within the reference frequency band of various battery cells;
Determining the placement position of various battery cells in the box according to the determined high risk level of lithium precipitation.

For example, taking the first frequency-domain impedance diagram as an example, suppose that three battery cells are screened out, and they are denoted as battery cell A, battery cell B, and battery cell C respectively. Each battery cell corresponds to a first frequency-domain impedance diagram, and assuming that the reference frequency band is 0.01Hz to 0.1Hz, that is, the peak Sp1; under the circumstances:
Finding the peak Sp1 from the first frequency-domain impedance diagram corresponding to the battery cell A and calculating the integral area, which is denoted as the integral area A;
Finding the peak Sp1 from the first frequency-domain impedance diagram corresponding to the battery cell B and calculating the integral area, which is denoted as the integral area B;
Finding the peak Sp1 from the first frequency-domain impedance diagram corresponding to the battery cell C and calculating the integral area, which is denoted as the integral area C.

If the three integral areas sorted in a descending order are: integral area A, integral area C, and integral area B, and it is assumed that the larger the integral area is, the higher the risk level of lithium precipitation is, and the smaller the integral area is, the lower the risk level of lithium precipitation is, it means that the lithium precipitation risk level of battery cell A is the highest, the lithium precipitation risk level of battery cell C is the second highest, and the lithium precipitation risk level of battery cell B is the lowest. Under the circumstances, the battery cell A may be set in a position where the temperature is higher or the current is lower in the box in order to reduce the probability of lithium precipitation in battery cell A, the battery cell B may be placed in a position where the temperature is lower or the current is higher in the box, and the battery cell C may be placed between battery cell A and battery cell B.

In this way, the placement position of various battery cells may be determined according to the lithium precipitation risk level of various cells that are screened out, thus preventing the probability of lithium precipitation from being increased when a battery cell with a higher lithium precipitation risk level is placed in a position that is likely to induce lithium precipitation. By optimizing the placement position, the probability of lithium precipitation is reduced, and the safety and reliability of the assembled battery set may be improved.

In some embodiments, the step of grouping the screened battery cells may further include:
Determining the intensity of the peak within the reference frequency band of the selected battery cells from the first frequency-domain impedance diagram or the second frequency-domain impedance diagram;
Determining the placement position of various battery cells in the box according to the intensity of the peak within the reference frequency band of various battery cells.

For example, also taking the first frequency-domain impedance diagram as an example, suppose that three battery cells are screened out, which are respectively denoted as battery cell A, battery cell B, and battery cell C. Each battery cell corresponds to a first frequency-domain impedance diagram, and also assuming that the reference frequency band is 0.01Hz to 0.1Hz, that is, the peak Sp1; under the circumstances:
If the peak intensities of the peak Sp1 of the three battery cells in a descending order are: battery cell B, battery cell A, and battery cell C, and it is assumed that the larger the peak intensity is, the higher the heat generated by the battery cell is, and the smaller the peak intensity of the battery cell is, the lower the heat generated by the battery cell is. Accordingly, it is reflected that the heat generated by the battery cell B is the highest, and the battery cell B may be placed away from the place where it is difficult to dissipate heat and close to the place where it is easy to dissipate heat, so as to ensure that the generated heat may be dissipated in time and effectively to avoid heat accumulation and safety hazard. The heat generated by the battery cell C is low, so the battery cell C may be placed close to the place where it is difficult to dissipate heat, and the battery cell A may be placed between the battery cell B and the battery cell C.

In this way, the placement position of various battery cells in the box may be determined according to the intensity of the peak in the reference frequency band of the screened out battery cells, so as to avoid heat accumulation caused by placing the battery cell that generates more heat in a position where it is difficult to dissipate heat, thereby avoiding thermal runaway and improving the safety and reliability of the assembled battery set.

Of course, in some embodiments, in addition to selecting the placement position based on the integral area and intensity of the peak in the reference frequency band of the battery cells, the placement position may also be selected based on other parameters of the peaks in the frequency-domain impedance diagram corresponding to the battery cells (such as but not limited to the width of the peak and so on). As long as the safety and reliability of the assembled battery set may be improved, the disclosure is not limited thereto.

The performance of the battery set assembled in the above manner is tested below.

Example: Take the first frequency-domain impedance diagram shown in FIG. 2 as an example, and it is exemplified that the peak intensity of the peak Sp3 is the first peak value, and the peak intensity of the peak Sp2 is the second peak value.

A reference battery cell is provided, and the characteristic value of the reference battery cell is calculated (denoted as R_{c}); the reference battery cell may be: a battery cell that has been fabricated and has been charged and discharged less than 10 times (which may be called a fresh battery cell) or any one of the multiple battery cells to be selected; the following is an example of the reference battery cell being a fresh battery cell.

The characteristic value of each battery cell in the plurality of battery cells to be selected is calculated.

The ratio of the characteristic value of each battery cell to the characteristic value of the reference battery cell is calculated, and the calculation results are shown in Table 1 below; where Rᵢ in Table 1 represents the characteristic value of each battery cell in the multiple battery cells to be selected. The consistency determining result indicates the consistency between each battery cell to be selected and the reference battery cell.

**Table 1**

| Rⱼ/R_{c} | Consistency determining result |
|---|---|
| <0.6 | Poor |
| 0.6-1.2 | Good |
| >1.2 | Poor |

It may be obtained from Table 1 that:
When Rᵢ/R_{c} is 0.6 to 1.2, that is, after the battery cells to be selected with the ratio of characteristic values in the range of 0.6 to 1.2 are selected and formed into groups, the obtained group of battery set has better consistency and health, and such battery set has excellent performance.

When Rᵢ/R_{c} is <0.6 and Rᵢ/R_{c} is >1.2, that is, after the battery cells to be selected with the ratio of characteristic values > 0.6 and Rᵢ/R_{c} is >1.2 are selected and formed into groups, the obtained group of battery set has poor consistency and health, and such battery set has poor performance.

Based on the same inventive concept, an embodiment of the present disclosure further provides a battery device, including: at least two battery cells, and the ratio of the characteristic values of any two battery cells is 0.6 to 1.2.

The method for determining the characteristic value of any battery cell is as follows:
Applying an excitation voltage signal and an excitation current signal to the battery cell respectively by using a preset frequency, and obtaining a corresponding response current signal and a corresponding response voltage signal; determining a frequency-domain based on the preset frequency, and determining a frequency-domain impedance diagram corresponding to the battery cell according to the response current signal, the response voltage signal, the frequency-domain and a preset transform algorithm;
When the preset transform algorithm is a Fourier transform algorithm, the determined frequency-domain impedance diagram is a first frequency-domain impedance diagram; determining a characteristic value of the battery cell based on a ratio of a first peak value to a second peak value within the range of 0.01Hz to 0.5Hz in the first frequency-domain impedance diagram; and the first peak value is: the intensity of the peak with the largest frequency among the frequencies corresponding to multiple peaks within 0.01Hz to 0.5Hz, and the second peak value is: the intensity of the peak with the smallest frequency among the frequencies corresponding to multiple peaks within 0.01 Hz to 0.5 Hz; when the preset transform algorithm is a wavelet transform algorithm, the determined frequency-domain impedance diagram is a second frequency-domain impedance diagram; determining the characteristic value of the battery cell based on the ratio of an integral area of the peak with the smaller frequency to a sum of the integral areas of the two peaks among the frequencies corresponding to the two peaks within the range of 10^{-2.5} Hz to 10^{0.5} Hz in the second frequency-domain impedance diagram.

The number of battery cells included in the battery device may be set according to actual needs, which is not limited herein.

In this way, the characteristic value is determined according to the ratio of the first peak value to the second peak value in the first frequency-domain impedance diagram, or determined according to the ratio of the integral area of the peak with a smaller frequency in the second frequency-domain impedance diagram, and each peak in the first frequency-domain impedance diagram and the second frequency-domain impedance diagram represents a composite impedance which at least includes diffusion impedance and charge transfer impedance. Different peaks correspond to different weights of diffusion impedance, and different peaks also correspond to different weights of charge transfer impedances. Therefore, the characteristic values can reflect the magnitude of the charge transfer impedance and diffusion impedance in each battery cell, and then reflect the characteristics of the interface and the characteristics of the solid phase particles during charging and discharging, and further reflect the health and performance of the battery cells. Accordingly, when the ratio of the characteristic values is determined based on the above, screening may be performed based on the ratio to screen out the battery cells that are consistent in terms of health and performance. In this manner, the consistency of the screened battery cells is better, and the performance of the formed battery set is improved.

Furthermore, the battery set screened in this way still have good consistency after storage and shelving, and the consistency between battery cells will not deteriorate after a certain period of storage, so that the battery device may have a better performance.

In some embodiments, the ratio of the characteristic values of any two battery cells is 0.9 to 1.1.

In this way, the characteristic values of any two battery cells may be made closer, thereby making the health and performance of the two battery cells closer, so that the screened battery cells are more consistent, thereby further improving the performance of the battery device.

In some embodiments, the characteristic value of any battery cell is 0.3 to 0.5.

In this way, the battery cells may be further screened based on the characteristic values of the battery cells, so that the consistency and health of the screened battery cells are more consistent, thereby further improving the performance of the battery device.

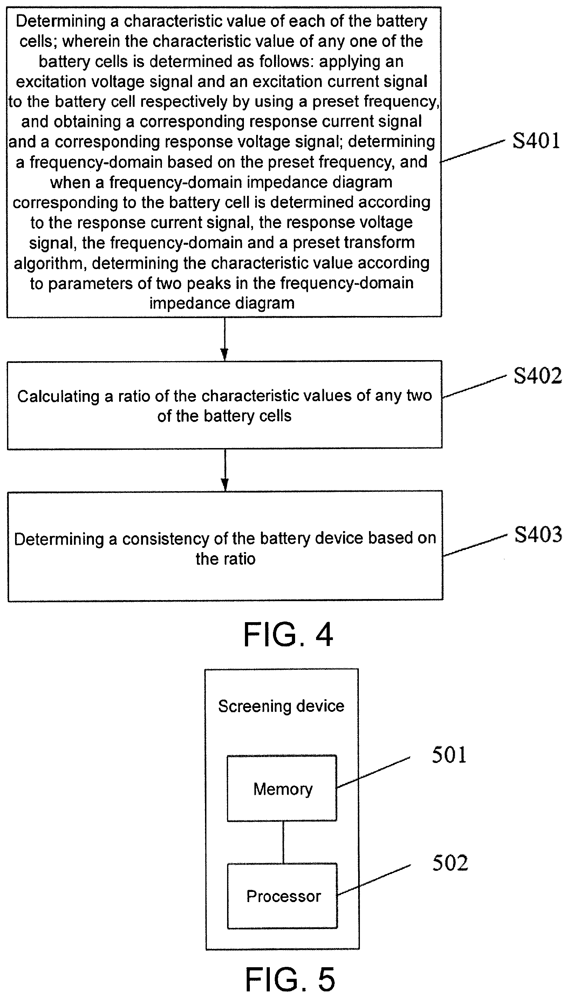

Based on the same inventive concept, an embodiment of the present disclosure further provides a detection method for a battery device. As shown in FIG. 4, the battery device includes a plurality of battery cells; the detection method includes:
S401. Determining the characteristic value of each battery cell, and the characteristic value of any one of the battery cells is determined as follows: applying an excitation voltage signal and an excitation current signal to the battery cell respectively by using a preset frequency, and obtaining a corresponding response current signal and a corresponding response voltage signal; determining a frequency-domain based on the preset frequency, and when a frequency-domain impedance diagram corresponding to the battery cell is determined according to the response current signal, the response voltage signal, the frequency-domain and a preset transform algorithm, determining the characteristic value according to the parameters of the two peaks in the frequency-domain impedance diagram;
The specific process of determining the characteristic value of each battery cell may be derived from the above content, and the details are not repeated here.
S402. Calculating a ratio of the characteristic values of any two battery cells;
S403. Determining the consistency of the battery device according to the ratio.

In this way, it is possible to dynamically monitor the consistency of each battery cell in the battery device, which may reflect the consistency of the battery cell during use, realize the online monitoring of the battery cell, and provide guidance for subsequent use of the battery device.

In some embodiments, the step of determining the consistency of the battery device according to the ratio includes:
Determining the maximum value of all ratios;
Determining the consistency level corresponding to the ratio range where the maximum value falls according to the preset corresponding relationship between the ratio range and the consistency level.

For example, the corresponding relationship between the ratio range and the consistency level may be shown in Table 2.

**Table 2**

| Ratio range | Consistency level |
|---|---|
| [c1, c2) | Excellent |
| [c2, c3) | Medium |
| [c3, c4) | Poor |

Assuming that the ratio range of the determined maximum value is [c2, c3), it means that the consistency level of the battery device is medium, indicating that the performance and service life of the battery device are at an average level.

Assuming that the ratio range of the determined maximum value is [c1, c2), it means that the consistency level of the battery device is excellent, indicating that the performance and service life of the battery device are good.

Assuming that the ratio range of the determined maximum value is [c3, c4), it means that the consistency level of the battery device is poor, indicating that the performance and service life of the battery device are both poor.

Of course, the corresponding relationship between the ratio range and the consistency level is not limited to what is shown in Table 2. Here, Table 2 only serves as an example for description. In actual situations, the corresponding relationship between the ratio range and the consistency level may be preset according to actual needs. The relationship is not limited here.

In this way, the consistency of the battery device may be determined based on the maximum value among all the ratios and the corresponding relationship between the ratio range and the consistency level, so as to provide a reference for the use of the battery device.

Of course, in some embodiments, in addition to determining the consistency of the battery device according to the maximum value among all the ratios, the method may further include:
Calculating the mean of all ratios, and determining the consistency level corresponding to the range of ratios in which the mean falls within.

In this way, the differences of all battery cells may be reflected, and the consistency of the battery device may be determined as a whole.

In some embodiments, the battery device is a battery pack, and the battery cells are battery modules or battery sets.

Or, when the battery device is a battery set or a battery module, the battery cell is a single cell.

Or, when the battery device is a containerized battery system, the battery cell is a battery pack.

In this way, the detection method may determine the consistency differences between three levels, i.e., containerized battery system, battery pack, and battery module (or battery set), and has a wide range of application fields and high practicability.

In some embodiments, early warning, display, and recording may also be performed based on the determined consistency of the battery device to provide data reference for subsequent battery performance improvement and analysis, and to provide users with more intuitive data, so that the users are able to be aware of performance changes of the battery device, and prepare for the occurrence of danger in advance, thus improving the safety of the battery device during use.

Based on the same inventive concept, an embodiment of the present disclosure provides a screening device for battery cells. The implementation principle of the screening device is similar to that of the screening method. For specific embodiments of the screening device, please refer to the specific implementation of the aforementioned screening method. The details will not be repeated.

Specifically, a screening device for battery cells provided by an embodiment of the present disclosure, as shown in FIG. 5, includes:
A memory 501, which is configured to store program instructions;
A processor 502, which is configured to invoke the program instructions stored in the memory 501, and execute the above-mentioned screening method provided by an embodiment of the present disclosure according to the obtained program.

Based on the same inventive concept, an embodiment of the present disclosure provides a detection device for a battery device. The implementation principle of the detection device is similar to that of the detection method. For specific embodiments of the detection device, please refer to the specific implementation of the aforementioned detection method. The details will not be repeated.

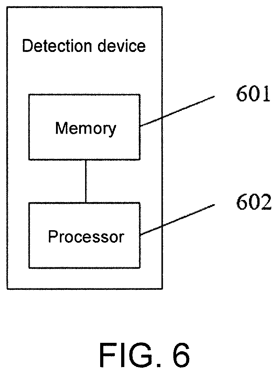

Specifically, a detection device for a battery device provided by an embodiment of the present disclosure, as shown in FIG. 6, includes:
A memory 601, which is configured to store program instructions;
A processor 602, which is configured to invoke the program instructions stored in the memory 601, and execute the above-mentioned detection method provided by an embodiment of the present disclosure according to the obtained program.

In some embodiments, the detection device may be a module in a battery management system, and the module may be an existing module in the battery management system, or may be a newly added module in the battery management system, as long as the detection function may be integrated into the battery management system.

It should be emphasized that the technical solutions provided by the embodiments of the present disclosure use the parameters of two peaks in the frequency-domain impedance diagram to determine the characteristic values of the battery cells, and the frequency-domain impedance diagram is significantly different from the electrochemical impedance analysis spectrum while having more advantages.

For example, in the process of obtaining the frequency-domain impedance diagram, the test process is simple, no complex test environment is required, and no special electrochemical workstation is required for testing.

The electrochemical impedance analysis spectrum is obtained after testing performed through the electrochemical workstation, so this spectrum is suitable for the test scene with small current, but most test scenes are found to be implemented with high current. In contrast, the frequency-domain impedance diagram may be applied to the test scenes with large current and small current, so there is no limitation to the test scenes. Accordingly, the frequency-domain impedance diagram is more adaptable for actual application.

It will be apparent to those skilled in the art that various modifications and variations can be made to the present disclosure without departing from the scope of the invention as defined in the appended claims. Thus, provided that these modifications and variations of the present disclosure fall within the scope of the claims of the present disclosure, the present disclosure is also intended to include these modifications and variations.

## Claims

1. A screening method for a battery device, the battery device comprising at least two battery cells, wherein a ratio of characteristic values of any two of the battery cells is 0.6 to 1.2, the screening method consisting of determining the characteristic value of any one of the battery cells and comprising:
applying an excitation voltage signal and an excitation current signal to a battery cell respectively by using a preset frequency, and obtaining a corresponding response current signal and a corresponding response voltage signal; determining a frequency-domain based on the preset frequency, and determining a frequency-domain impedance diagram corresponding to the battery cell according to the response current signal, the response voltage signal, the frequency-domain and a preset transform algorithm (S101);
**characterised in that** the method further comprises:
when the preset transform algorithm is a Fourier transform algorithm, the determined frequency-domain impedance diagram is a first frequency-domain impedance diagram; determining a characteristic value of the battery cell based on a ratio of a first peak value to a second peak value within a range of 0.01Hz to 0.5Hz in the first frequency-domain impedance diagram; wherein the first peak value is: an intensity of a peak with the largest frequency among frequencies corresponding to a plurality of peaks within the range of 0.01Hz to 0.5Hz, and the second peak value is: an intensity of a peak with the smallest frequency among the frequencies corresponding to the plurality of peaks within the range of 0.01 Hz to 0.5 Hz; when the preset transform algorithm is a wavelet transform algorithm, the determined frequency-domain impedance diagram is a second frequency-domain impedance diagram; determining the characteristic value of the battery cell based on a ratio of an integral area of a peak with a smaller frequency to a sum of integral areas of two peaks among frequencies corresponding to the two peaks within a range of 10^{-2.5} Hz to 10^{0.5} Hz in the second frequency-domain impedance diagram.

2. The screening method according to claim 1, wherein the ratio of the characteristic values of any two of the battery cells is 0.9 to 1.1.

3. The screening method according to claim 1 or 2, wherein the characteristic value of any one of the battery cells is 0.3 to 0.5.

4. A screening method for a battery cell, the screening method comprising:
determining a characteristic value of each of a plurality of battery cells to be selected; wherein the characteristic value of any one of the battery cells is determined as follows: applying an excitation voltage signal and an excitation current signal to the battery cell respectively by using a preset frequency, and obtaining a corresponding response current signal and a corresponding response voltage signal; determining a frequency-domain based on the preset frequency, and determining a frequency-domain impedance diagram corresponding to the battery cell according to the response current signal, the response voltage signal, the frequency-domain and a preset transform algorithm,
**characterised in that** the method further comprises:
determining the characteristic value according to parameters of two peaks in the frequency-domain impedance diagram (S101);
calculating a ratio of the characteristic values of any two of the battery cells (S102);
selecting the battery cells having the ratios in a first preset range (S103).

5. The screening method according to claim 4, wherein the step of determining the frequency-domain based on the preset frequency comprises:
using one-half of the preset frequency as the maximum frequency;
determining zero to the maximum frequency as the frequency-domain.

6. The screening method according to claim 4, wherein the step of determining the frequency-domain impedance diagram according to the response current signal, the response voltage signal, the frequency-domain, and the preset transform algorithm comprises:
transforming the response current signal and the response voltage signal by using the preset transform algorithm based on the frequency-domain, thereby obtaining a corresponding relationship between the response current signal and the frequency-domain, and a corresponding relationship between the response voltage signal and the frequency-domain;
determining the frequency-domain impedance diagram according to each of the corresponding relationships;
wherein when the preset transform algorithm is a Fourier transform algorithm, the frequency-domain impedance diagram is a first frequency-domain impedance diagram; when the preset transform algorithm is a wavelet transform algorithm, the frequency-domain impedance diagram is a second frequency-domain impedance diagram.

7. The screening method according to any one of claims 4-6, wherein the step of determining the characteristic value according to the parameters of the two peaks in the frequency-domain impedance diagram comprises:
determining the characteristic value according to a peak value ratio of two of a plurality of peaks within a range of 0.01 Hz to 0.5 Hz in the first frequency-domain impedance diagram when the frequency-domain impedance diagram is the first frequency-domain impedance diagram obtained based on the Fourier transform algorithm;
or determining the characteristic value according to an integral area ratio of one of the two peaks in a range of 10^{-2.5}Hz to 10^{0.5}Hz in the second frequency-domain impedance diagram when the frequency-domain impedance diagram is the second frequency-domain impedance diagram obtained based on the wavelet transform algorithm.

8. The screening method according to claim 7, wherein the step of determining the characteristic value according to the peak value ratio of the two of the plurality of peaks within the range of 0.01 Hz to 0.5 Hz in the first frequency-domain impedance diagram comprises:
determining a frequency corresponding to each peak in the plurality of peaks within the range of 0.01Hz to 0.5Hz in the first frequency-domain impedance diagram;
defining a peak intensity of a peak with the largest frequency among the plurality of peaks as a first peak value, and defining a peak intensity of a peak with the smallest frequency among the plurality of peaks as a second peak value;
determining the characteristic value according to a ratio of the first peak value to the second peak value.

9. The screening method according to claim 7, wherein the step of determining the characteristic value according to the integral area ratio of the one of the two peaks in the range of 10^{-2.5}Hz to 10^{0.5}Hz in the second frequency-domain impedance diagram comprises:
determining an integral area of each of the two peaks within the range of 10^{-2.5} Hz to 10^{0.5} Hz in the second frequency-domain impedance diagram;
determining the characteristic value according to a ratio of an integral area of a peak with a smaller frequency to a sum of the integral areas of the two peaks.

10. The screening method according to claim 4, further comprising:
continuously selecting the battery cells with the characteristic values in a range of 0.3 to 0.5 from among the selected battery cells.

11. A detection method for a battery device, wherein the battery device comprises a plurality of battery cells; the detection method comprising:
determining a characteristic value of each of the battery cells; wherein the characteristic value of any one of the battery cells is determined as follows: applying an excitation voltage signal and an excitation current signal to the battery cell respectively by using a preset frequency, and obtaining a corresponding response current signal and a corresponding response voltage signal; determining a frequency-domain based on the preset frequency, and when a frequency-domain impedance diagram corresponding to the battery cell is determined according to the response current signal, the response voltage signal, the frequency-domain and a preset transform algorithm,
**characterised in that** the method further comprises:
determining the characteristic value according to parameters of two peaks in the frequency-domain impedance diagram (S101);
calculating a ratio of the characteristic values of any two of the battery cells (S102);
determining a consistency of the battery device based on the ratio (S103).

12. The detection method according to claim 11, wherein the step of determining the consistency of the battery device according to the ratio comprises:
determining a consistency level corresponding to a ratio range where the maximum value falls according to a preset corresponding relationship between the ratio range and the consistency level.

13. A screening device for a battery cell, comprising:
means for applying an excitation voltage signal and an excitation current signal to the battery cell by using a preset frequency;
a memory (501), which is configured to store program instructions;
a processor (502), which is configured to invoke the program instructions stored in the memory, and execute the screening method as claimed in any one of claims 4-10 according to an obtained program.

14. A detection device for a battery device, wherein the battery device comprises a plurality of battery cells, the detection device comprising:
means for applying an excitation voltage signal and an excitation current signal to the battery cell by using a preset frequency;
a memory (601), which is configured to store program instructions;
a processor (602), which is configured to invoke the program instructions stored in the memory, and execute the detection method as claimed in claim 11 or 12 according to an obtained program.

## Patentansprüche

1. Screeningverfahren für eine Batterievorrichtung, wobei die Batterievorrichtung mindestens zwei Batteriezellen umfasst, wobei ein Verhältnis der Kennwerte von zwei beliebigen der Batteriezellen 0,6 bis 1,2 beträgt, wobei das Screeningverfahren darin besteht, den Kennwert einer beliebigen der Batteriezellen zu bestimmen, und umfasst:
Anlegen eines Anregungsspannungssignals und eines Anregungsstromsignals an eine Batteriezelle jeweils unter Verwendung einer voreingestellten Frequenz und Erhalten eines entsprechenden Antwortstromsignals und eines entsprechenden Antwortspannungssignals; Bestimmen eines Frequenzbereichs auf der Grundlage der voreingestellten Frequenz und Bestimmen eines der Batteriezelle entsprechenden Frequenzbereichsimpedanzdiagramms gemäß dem Antwortstromsignal, dem Antwortspannungssignal, dem Frequenzbereich und einem voreingestellten Transformationsalgorithmus (S101);
**dadurch gekennzeichnet, dass** das Verfahren ferner umfasst:
wenn der voreingestellte Transformationsalgorithmus ein Fourier-Transformationsalgorithmus ist, ist das bestimmte Frequenzbereichsimpedanzdiagramm ein erstes Frequenzbereichsimpedanzdiagramm; Bestimmen eines Kennwerts der Batteriezelle auf der Grundlage eines Verhältnisses eines ersten Spitzenwerts zu einem zweiten Spitzenwert innerhalb eines Bereichs von 0,01 Hz bis 0,5 Hz in dem ersten Frequenzbereichsimpedanzdiagramm; wobei der erste Spitzenwert ist: eine Intensität einer Spitze mit der größten Frequenz unter den Frequenzen, die einer Vielzahl von Spitzen innerhalb des Bereichs von 0,01 Hz bis 0,5 Hz entsprechen, und der zweite Spitzenwert ist: eine Intensität einer Spitze mit der kleinsten Frequenz unter den Frequenzen, die einer Vielzahl von Spitzen in dem Bereich von 0,01 Hz bis 0,5 Hz entsprechen; wenn der voreingestellte Transformationsalgorithmus ein Wavelet-Transformationsalgorithmus ist, ist das bestimmte Frequenzbereichsimpedanzdiagramm ein zweites Frequenzbereichsimpedanzdiagramm; Bestimmen des Kennwerts der Batteriezelle auf der Grundlage eines Verhältnisses einer Integralfläche einer Spitze mit einer geringeren Frequenz zu einer Summe von Integralflächen von zwei Spitzen unter den Frequenzen, die den zwei Spitzen innerhalb eines Bereichs von 10^{-2,5} Hz bis 10^{0,5} Hz in dem zweiten Frequenzbereichsimpedanzdiagramm entsprechen.

2. Screeningverfahren nach Anspruch 1, wobei das Verhältnis der Kennwerte von zwei beliebigen der Batteriezellen 0,9 bis 1,1 beträgt.

3. Screeningverfahren nach Anspruch 1 oder 2, wobei der Kennwert einer beliebigen der Batteriezellen 0,3 bis 0,5 beträgt.

4. Screeningverfahren für eine Batteriezelle, wobei das Screeningverfahren umfasst:
Bestimmen eines Kennwerts jeder aus einer Vielzahl auszuwählender Batteriezellen; wobei der Kennwert einer beliebigen der Batteriezellen wie folgt bestimmt wird: Anlegen eines Anregungsspannungssignals und eines Anregungsstromsignals an die Batteriezelle jeweils unter Verwendung einer voreingestellten Frequenz und Erhalten eines entsprechenden Antwortstromsignals und eines entsprechenden Antwortspannungssignals; Bestimmen eines Frequenzbereichs auf der Grundlage der voreingestellten Frequenz und Bestimmen eines der Batteriezelle entsprechenden Frequenzbereichsimpedanzdiagramms gemäß dem Antwortstromsignal, dem Antwortspannungssignal, dem Frequenzbereich und einem voreingestellten Transformationsalgorithmus,
**dadurch gekennzeichnet, dass** das Verfahren ferner umfasst:
Bestimmen des Kennwerts gemäß Parametern von zwei Spitzen in dem Frequenzbereichsimpedanzdiagramm (S101);
Berechnen eines Verhältnisses der Kennwerte beliebiger zweier der Batteriezellen (S102);
Auswählen der Batteriezellen, deren Verhältnisse in einem ersten voreingestellten Bereich liegen (S103).

5. Screeningverfahren nach Anspruch 4, wobei der Schritt des Bestimmens des Frequenzbereichs auf der Grundlage der voreingestellten Frequenz umfasst:
Verwenden der Hälfte der voreingestellten Frequenz als die maximale Frequenz;
Bestimmen von Null bis zu der maximalen Frequenz als den Frequenzbereich.

6. Screeningverfahren nach Anspruch 4, wobei der Schritt des Bestimmens des Frequenzbereichsimpedanzdiagramms gemäß dem Antwortstromsignal, dem Antwortspannungssignal, dem Frequenzbereich und dem voreingestellten Transformationsalgorithmus umfasst:
Transformieren des Antwortstromsignals und des Antwortspannungssignals unter Verwendung des voreingestellten Transformationsalgorithmus auf der Grundlage des Frequenzbereichs, wodurch eine entsprechende Beziehung zwischen dem Antwortstromsignal und dem Frequenzbereich und eine entsprechende Beziehung zwischen dem Antwortspannungssignal und dem Frequenzbereich erhalten wird;
Bestimmen des Frequenzbereichsimpedanzdiagramms gemäß jeder der entsprechenden Beziehungen;
wobei, wenn der voreingestellte Transformationsalgorithmus ein Fourier-Transformationsalgorithmus ist, das Frequenzbereichsimpedanzdiagramm ein erstes Frequenzbereichsimpedanzdiagramm ist; wenn der voreingestellte Transformationsalgorithmus ein Wavelet-Transformationsalgorithmus ist, das Frequenzbereichsimpedanzdiagramm ein zweites Frequenzbereichsimpedanzdiagramm ist.

7. Screeningverfahren gemäß einem der Ansprüche 4-6, wobei der Schritt des Bestimmens des Kennwerts gemäß den Parametern der zwei Spitzen in dem Frequenzbereichsimpedanzdiagramm umfasst:
Bestimmen des Kennwerts gemäß einem Spitzenwertverhältnis von zwei aus einer Vielzahl von Spitzen innerhalb eines Bereichs von 0,01 Hz bis 0,5 Hz in dem ersten Frequenzbereichsimpedanzdiagramm, wenn das Frequenzbereichsimpedanzdiagramm das erste Frequenzbereichsimpedanzdiagramm ist, das auf der Grundlage des Fourier-Transformationsalgorithmus erhalten wurde;
oder Bestimmen des Kennwerts gemäß einem Integralflächenverhältnis einer der zwei Spitzen in einem Bereich von 10^{-2,5} Hz bis 10^{0,5} Hz in dem zweiten Frequenzbereichsimpedanzdiagramm, wenn das Frequenzbereichsimpedanzdiagramm das zweite Frequenzbereichsimpedanzdiagramm ist, das auf der Grundlage des Wavelet-Transformationsalgorithmus erhalten wurde.

8. Screeningverfahren nach Anspruch 7, wobei der Schritt des Bestimmens des Kennwerts gemäß dem Spitzenwertverhältnis der zwei Spitzen aus der Vielzahl von Spitzen innerhalb des Bereichs von 0,01 Hz bis 0,5 Hz in dem ersten Frequenzbereichsimpedanzdiagramm umfasst:
Bestimmen einer Frequenz, die jeder Spitze der Vielzahl von Spitzen in dem Bereich von 0,01 Hz bis 0,5 Hz in dem ersten Frequenzbereichsimpedanzdiagramm entspricht;
Definieren einer Spitzenintensität einer Spitze mit der größten Frequenz unter der Vielzahl von Spitzen als einen ersten Spitzenwert und Definieren einer Spitzenintensität einer Spitze mit der kleinsten Frequenz unter der Vielzahl von Spitzen als einen zweiten Spitzenwert;
Bestimmen des Kennwerts gemäß einem Verhältnis des ersten Spitzenwerts zu dem zweiten Spitzenwert.

9. Screeningverfahren nach Anspruch 7, wobei der Schritt des Bestimmens des Kennwerts gemäß dem Integralflächenverhältnis der einen der zwei Spitzen in dem Bereich von 10^{-2,5} Hz bis 10^{0,5} Hz in dem zweiten Frequenzbereichsimpedanzdiagramm umfasst:
Bestimmen einer Integralfläche jeder der zwei Spitzen innerhalb des Bereichs von 10^{-2,5} Hz bis 10^{0,5} Hz in dem zweiten Frequenzbereichsimpedanzdiagramm;
Bestimmen des Kennwerts gemäß einem Verhältnis einer Integralfläche einer Spitze mit einer niedrigeren Frequenz zu einer Summe der Integralflächen der zwei Spitzen.

10. Screeningverfahren nach Anspruch 4, ferner umfassend:
kontinuierliches Auswählen der Batteriezellen mit den Kennwerten in einem Bereich von 0,3 bis 0,5 aus den ausgewählten Batteriezellen.

11. Erkennungsverfahren für eine Batterievorrichtung, wobei die Batterievorrichtung eine Vielzahl von Batteriezellen umfasst; wobei das Erkennungsverfahren umfasst:
Bestimmen eines Kennwerts jeder der Batteriezellen; wobei der Kennwert einer beliebigen der Batteriezellen wie folgt bestimmt wird: Anlegen eines Anregungsspannungssignals und eines Anregungsstromsignals an die Batteriezelle jeweils unter Verwendung einer voreingestellten Frequenz und Erhalten eines entsprechenden Antwortstromsignals und eines entsprechenden Antwortspannungssignals; Bestimmen eines Frequenzbereichs auf der Grundlage der voreingestellten Frequenz, und wenn ein der Batteriezelle entsprechendes Frequenzbereichsimpedanzdiagramm gemäß dem Antwortstromsignal, dem Antwortspannungssignal, dem Frequenzbereich und einem voreingestellten Transformationsalgorithmus bestimmt wird,
**dadurch gekennzeichnet, dass** das Verfahren ferner umfasst:
Bestimmen des Kennwerts gemäß Parametern von zwei Spitzen in dem Frequenzbereichsimpedanzdiagramm (S101);
Berechnen eines Verhältnisses der Kennwerte von zwei beliebigen der Batteriezellen (S102);
Bestimmen einer Konsistenz der Batterievorrichtung auf der Grundlage des Verhältnisses (S103).

12. Erkennungsverfahren nach Anspruch 11, wobei der Schritt des Bestimmens der Konsistenz der Batterievorrichtung gemäß dem Verhältnis umfasst:
Bestimmen eines Konsistenzniveaus, das einem Verhältnisbereich entspricht, in den der Maximalwert fällt, gemäß einer voreingestellten entsprechenden Beziehung zwischen dem Verhältnisbereich und dem Konsistenzniveau.

13. Screeningvorrichtung für eine Batteriezelle, umfassend:
Mittel zum Anlegen eines Anregungsspannungssignals und eines Anregungsstromsignals an die Batteriezelle unter Verwendung einer voreingestellten Frequenz;
einen Speicher (501), der so konfiguriert ist, dass er Programmbefehle speichert;
einen Prozessor (502), der so konfiguriert ist, dass er die in dem Speicher gespeicherten Programmbefehle aufruft und das in einem der Ansprüche 4-10 beanspruchte Screeningverfahren gemäß einem erhaltenen Programm ausführt.

14. Erkennungsvorrichtung für eine Batterievorrichtung, wobei die Batterievorrichtung eine Vielzahl von Batteriezellen umfasst, wobei die Erkennungsvorrichtung umfasst:
Mittel zum Anlegen eines Anregungsspannungssignals und eines Anregungsstromsignals an die Batteriezelle unter Verwendung einer voreingestellten Frequenz;
einen Speicher (601), der so konfiguriert ist, dass er Programmbefehle speichert;
einen Prozessor (602), der so konfiguriert ist, dass er die in dem Speicher gespeicherten Programmbefehle aufruft und das in Anspruch 11 oder 12 beanspruchte Erkennungsverfahren gemäß einem erhaltenen Programm ausführt.

## Revendications

1. Procédé de criblage pour un dispositif de batterie, ledit dispositif de batterie comprenant au moins deux cellules de batterie, dans lequel le rapport entre les valeurs caractéristiques de deux cellules quelconques parmi lesdites cellules de batterie est compris entre 0,6 et 1,2,
ledit procédé de criblage consistant à déterminer la valeur caractéristique de l'une quelconque desdites cellules de batterie et comprenant :
l'application d'un signal de tension d'excitation et d'un signal de courant d'excitation à une cellule de batterie respectivement en utilisant une fréquence prédéfinie, et
l'obtention d'un signal de courant de réponse correspondant et d'un signal de tension de réponse correspondant ;
la détermination d'un domaine fréquentiel sur la base de la fréquence prédéfinie, et la détermination d'un diagramme d'impédance dans le domaine fréquentiel correspondant à la cellule de batterie en fonction du signal de courant de réponse, du signal de tension de réponse, du domaine fréquentiel et d'un algorithme de transformation prédéfini (S101) ; **caractérisé en ce que** le procédé comprend en outre :
lorsque l'algorithme de transformation prédéfini est un algorithme de transformation de Fourier, le diagramme d'impédance dans le domaine fréquentiel déterminé est un premier diagramme d'impédance dans le domaine fréquentiel ; déterminer une valeur caractéristique de la cellule de batterie sur la base d'un rapport entre une première valeur de crête et une deuxième valeur de crête dans une plage de 0,01 Hz à 0,5 Hz dans le premier diagramme d'impédance dans le domaine fréquentiel ; dans lequel la première valeur de crête est : une intensité d'un pic ayant la plus grande fréquence parmi les fréquences correspondant à une pluralité de pics dans la plage de 0,01 Hz à 0,5 Hz, et la deuxième valeur de crête est : une intensité d'un pic ayant la plus petite fréquence parmi les fréquences correspondant à la pluralité de pics dans la plage de 0,01 Hz à 0,5 Hz ; lorsque l'algorithme de transformation prédéfini est un algorithme de transformation en ondelettes, le diagramme d'impédance dans le domaine fréquentiel déterminé est un deuxième diagramme d'impédance dans le domaine fréquentiel ; déterminer la valeur caractéristique de la cellule de batterie sur la base d'un rapport entre l'aire intégrée d'un pic ayant une fréquence plus faible et la somme des aires intégrées de deux pics parmi les fréquences correspondant aux deux pics compris dans une plage de 10^{-2,5} Hz à 10^{0,5} Hz dans le deuxième diagramme d'impédance dans le domaine fréquentiel.

2. Procédé de criblage selon la revendication 1, dans lequel le rapport des valeurs caractéristiques de deux cellules de batterie quelconques est compris entre 0,9 et 1,1.

3. Procédé de criblage selon la revendication 1 ou 2, dans lequel la valeur caractéristique de l'une quelconque des cellules de batterie est comprise entre 0,3 et 0,5.

4. Procédé de criblage d'une cellule de batterie, le procédé de criblage comprenant :
la détermination d'une valeur caractéristique de chacune d'une pluralité de cellules de batterie à sélectionner ; dans lequel la valeur caractéristique de l'une quelconque des cellules de batterie est déterminée comme suit :
l'application d'un signal de tension d'excitation et d'un signal de courant d'excitation à la cellule de batterie respectivement en utilisant une fréquence prédéfinie, et l'obtention d'un signal de courant de réponse correspondant et d'un signal de tension de réponse correspondant ; déterminer un domaine fréquentiel sur la base de la fréquence prédéfinie, et déterminer un diagramme d'impédance dans le domaine fréquentiel correspondant à la cellule de batterie en fonction du signal de courant de réponse, du signal de tension de réponse, du domaine fréquentiel et d'un algorithme de transformation prédéfini, **caractérisé en ce que** le procédé comprend en outre :déterminer la valeur caractéristique en fonction des paramètres de deux pics dans le diagramme d'impédance dans le domaine fréquentiel (S101) ;le calcul d'un rapport entre les valeurs caractéristiques de deux cellules de batterie quelconques (S102) ;la sélection des cellules de batterie présentant des rapports compris dans une première plage prédéfinie (S103).

5. Procédé de criblage selon la revendication 4, dans lequel l'étape consistant à
déterminer le domaine fréquentiel sur la base de la fréquence prédéfinie comprend :
l'utilisation de la moitié de la fréquence prédéfinie comme fréquence maximale ;la détermination d'une plage allant de zéro à la fréquence maximale comme domaine fréquentiel.

6. Procédé de criblage selon la revendication 4, dans lequel l'étape consistant à déterminer le diagramme d'impédance dans le domaine fréquentiel en fonction du signal de courant de réponse, du signal de tension de réponse, du domaine fréquentiel et de l'algorithme de transformation prédéfini comprend :
la transformation du signal de courant de réponse et du signal de tension de réponse à l'aide de l'algorithme de transformation prédéfini basé sur le domaine fréquentiel, obtenant ainsi une relation correspondante entre le signal de courant de réponse et le domaine fréquentiel, et une relation correspondante entre le signal de tension de réponse et le domaine fréquentiel ;
la détermination du diagramme d'impédance dans le domaine fréquentiel en fonction de chacune des relations correspondantes ;
dans lequel, lorsque l'algorithme de transformation prédéfini est un algorithme de transformée de Fourier, le diagramme d'impédance dans le domaine fréquentiel est un premier diagramme d'impédance dans le domaine fréquentiel ; lorsque l'algorithme de transformation prédéfini est un algorithme de transformée en ondelettes, le diagramme d'impédance dans le domaine fréquentiel est un deuxième diagramme d'impédance dans le domaine fréquentiel.

7. Procédé de criblage selon l'une quelconque des revendications 4 à 6, dans lequel l'étape consistant à déterminer la valeur caractéristique en fonction des paramètres des deux pics dans le diagramme d'impédance dans le domaine fréquentiel comprend:
la détermination de la valeur caractéristique en fonction d'un rapport de valeurs de crête entre deux d'une pluralité de pics situés dans une plage de 0,01 Hz à 0,5 Hz dans le premier diagramme d'impédance dans le domaine fréquentiel lorsque le diagramme d'impédance dans le domaine fréquentiel est le premier diagramme d'impédance dans le domaine fréquentiel obtenu sur la base de l'algorithme de transformée de Fourier ;ou la détermination de la valeur caractéristique en fonction d'un rapport d'aire intégrée de l'un des deux pics dans une plage de 10^{-2,5} Hz à 10^{0,5} Hz dans le deuxième diagramme d'impédance dans le domaine fréquentiel lorsque le diagramme d'impédance dans le domaine fréquentiel est le deuxième diagramme d'impédance dans le domaine fréquentiel obtenu sur la base de l'algorithme de transformée en ondelettes.

8. Procédé de criblage selon la revendication 7, dans lequel l'étape consistant à déterminer la valeur caractéristique en fonction du rapport des valeurs de crête de deux des multiples pics compris dans la plage de 0,01 Hz à 0,5 Hz dans le premier diagramme d'impédance dans le domaine fréquentiel comprend :
la détermination d'une fréquence correspondant à chaque pic parmi la pluralité de pics compris dans la plage de 0,01 Hz à 0,5 Hz dans le premier diagramme d'impédance dans le domaine fréquentiel ;
la définition d'une intensité de pic du pic ayant la fréquence la plus élevée parmi la pluralité de pics comme première valeur de pic, et la définition d'une intensité de pic du pic ayant la fréquence la plus faible parmi la pluralité de pics comme deuxième valeur de pic ;déterminer la valeur caractéristique en fonction d'un rapport entre la première valeur de crête et la deuxième valeur de crête.

9. Procédé de criblage selon la revendication 7, dans lequel l'étape consistant à déterminer la valeur caractéristique en fonction du rapport des aires intégrées de l'un des deux pics compris dans la plage de 10^{-2,5} Hz à 10^{0,5} Hz dans le deuxième diagramme d'impédance dans le domaine fréquentiel comprend :
déterminer une aire intégrée de chacun des deux pics dans la plage de 10^{-2,5} Hz à 10^{0,5} Hz dans le deuxième diagramme d'impédance dans le domaine fréquentiel ;
déterminer la valeur caractéristique en fonction d'un rapport entre l'aire intégrée d'un pic ayant la fréquence la plus faible et la somme des aires intégrées des deux pics.

10. Procédé de criblage selon la revendication 4, comprenant en outre :
la sélection en continu des cellules de batterie présentant des valeurs caractéristiques comprises dans une plage de 0,3 à 0,5 parmi les cellules de batterie sélectionnées.

11. Procédé de détection pour un dispositif de batterie, dans lequel le dispositif de batterie comprend une pluralité de cellules de batterie ; le procédé de détection comprenant :
la détermination d'une valeur caractéristique de chacune des cellules de batterie ; dans lequel la valeur caractéristique de l'une quelconque des cellules de batterie est déterminée comme suit : l'application d'un signal de tension d'excitation et d'un signal de courant d'excitation à la cellule de batterie respectivement en utilisant une fréquence prédéfinie, et l'obtention d'un signal de courant de réponse correspondant et d'un signal de tension de réponse correspondant ; déterminer un domaine fréquentiel sur la base de la fréquence prédéfinie, et lorsqu'un diagramme d'impédance dans le domaine fréquentiel correspondant à la cellule de batterie est déterminé en fonction du signal de courant de réponse, du signal de tension de réponse, du domaine fréquentiel et d'un algorithme de transformation prédéfini, **caractérisé en ce que** le procédé comprend en outre :
la détermination de la valeur caractéristique en fonction des paramètres de deux pics dans le diagramme d'impédance dans le domaine fréquentiel (S101);
le calcul d'un rapport entre les valeurs caractéristiques de deux cellules de batterie quelconques (S102) ;
la détermination d'une cohérence du dispositif de batterie sur la base dudit rapport (S103).

12. Procédé de détection selon la revendication 11, dans lequel l'étape de détermination de la cohérence du dispositif de batterie en fonction dudit rapport comprend :
la détermination de la valeur maximale de tous les rapports ;
la détermination d'un niveau de cohérence correspondant à une plage de rapports dans laquelle se situe la valeur maximale, selon une relation prédéfinie entre la plage de rapports et le niveau de cohérence.

13. Dispositif de contrôle pour une cellule de batterie, comprenant :
des moyens pour appliquer un signal de tension d'excitation et un signal de courant d'excitation à la cellule de batterie en utilisant une fréquence prédéfinie ;
une mémoire (501), qui est configurée pour stocker des instructions de programme ;
un processeur (502), qui est configuré pour invoquer les instructions de programme stockées dans la mémoire, et exécuter procédé de criblage selon l'une quelconque des revendications 4 à 10 selon un programme obtenu.

14. Dispositif de détection pour un dispositif de batterie, dans lequel le dispositif de batterie comprend une pluralité de cellules de batterie, le dispositif de détection comprenant :
des moyens pour appliquer un signal de tension d'excitation et un signal de courant d'excitation à la cellule de batterie en utilisant une fréquence prédéfinie,
une mémoire (601), qui est configurée pour stocker des instructions de programme ;
un processeur (602), qui est configuré pour invoquer les instructions de programme stockées dans la mémoire, et exécuter le procédé de détection selon l'une des revendications 11 ou 12 conformément à un programme obtenu.
